# EUROPEAN PATENT APPLICATION

(11) **EP 1 677 357 A1**
(43) Date of publication of application: **05.07.2006**
(21) Application number: 04107069.9
(22) Date of filing: 30.12.2004
(51) Int. Cl.: H01L 27/24, H01L 45/00

(54) **Phase change memory device having an adhesion layer and manufacturing process thereof**

(71) Applicant: STMicroelectronics S.r.l., 20041 Agrate Brianza (Milano) (IT)
(72) Inventor: Chang, Kuo-Wei, Santa Clara CA 95052 (US); Lee, Jong-Won S., San Francisco CA 94107 (US); Besana, Paola, 20010 Bareggio (IT)
(74) Representative: Jorio, Paolo

(57) **Abstract**

A memory includes a phase change memory element having a memory layer (350) of a calcogenide material and an adhesion layer (1000,1002,1004,1006,1008,1010) of an alloy of the form TiₐX_{b}N_{c} where X is selected in the group comprising silicon, aluminum, carbon, or boron, and c may be 0. The nitrogen and silicon are adapted to reduce the diffusion of titanium toward the chalcogenide layer.

## Description

This invention relates generally to a phase change memory device having an adhesion layer and to the manufacturing process thereof.

Phase change memory devices use phase change materials, i.e., materials that may be electrically switched between a generally amorphous and a generally crystalline state, for electronic memory application. One type of memory element utilizes a phase change material that is electrically switched between a structural state of generally amorphous and generally crystalline local order or between different detectable states of local order across the entire spectrum between completely amorphous and completely crystalline states. The state of the phase change materials is also non-volatile in that, when set in either a crystalline, semi-crystalline, amorphous, or semi-amorphous state representing a resistance value, that value is retained until changed by another programming event, as that value represents a phase or physical state of the material (e.g., crystalline or amorphous). The state is unaffected by removing electrical power.

A chalcogenide alloy is generally used as a phase change material. A chalcogenide material is a material that includes at least one element from column VI of the periodic table or a material that includes one or more of the chalcogen elements, e.g., any of the elements of tellurium, sulfur, or selenium. Presently, the chalcogenide that offers the most promise is formed by a Ge, Sb and Te alloy (Ge₂Sb₂Te₅), also called GST, which is currently widely used for storing information in overwritable disks.

Phase change memory devices often require a glue or adhesion layer to improve the adherence of the chalcogenide material to one or more adjacent layers. In fact, it is very difficult to integrate GST alloys into semiconductor processing since they do not adhere to most of the stable dielectrics. Some metallic materials (e.g. Ti) show good adhesion with GST alloys, but they tend to diffuse into GST alloys, react with the constituent elements, and kill the phase change capability.

Thus, the object of the invention is to find a glue material with good adhesion and less diffusion in GST alloys than present materials.

According to the present invention, there are provided a phase change device and the manufacturing method thereof, as defined respectively in claims 1 and 12.

For the understanding of the present invention, a preferred embodiment is now described, purely as a non-limitative example, with reference to the enclosed drawings, wherein:
Fig. 1 is a schematic diagram illustrating a memory in accordance with one embodiment of the present invention;
Fig. 2 is a diagram illustrating a current-voltage characteristic of an access device;
Fig. 3 is a diagram illustrating a current-voltage characteristic of a combination access device;
Fig. 4 is a cross-sectional view of a portion of the memory illustrated in Fig. 1 in accordance with an embodiment of the present invention; and
Fig. 5 is a block diagram illustrating a portion of a system in accordance with an embodiment of the present invention.

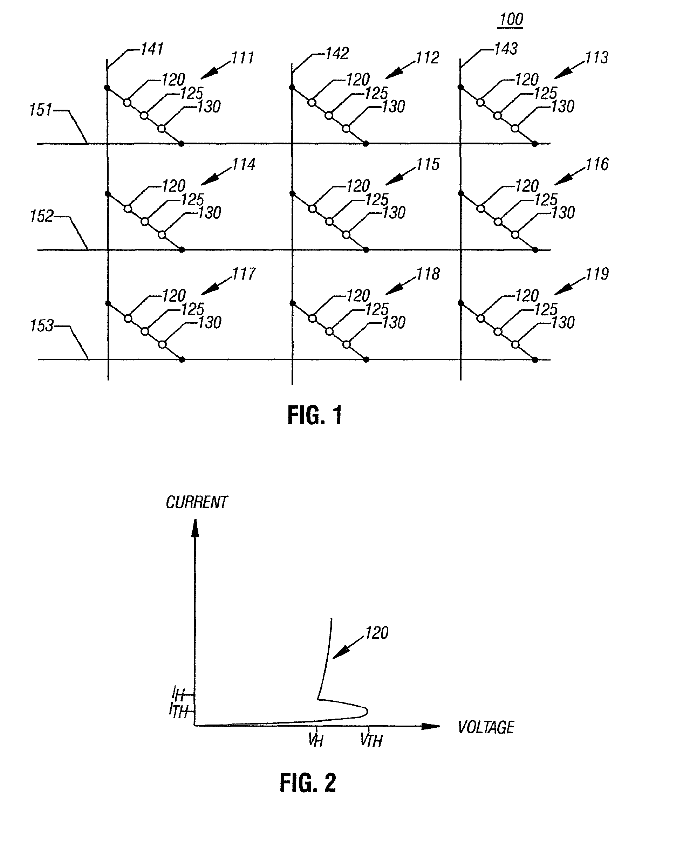

Fig. 1 shows an embodiment of a memory 100. Memory 100 includes an nXn array of memory cells 111-119, each including a first select device 120, a second select device 125, and a memory element 130.

Memory elements 130 comprises a phase change material and thus may be referred to as a phase change memory. A phase change material is a material having electrical properties (e.g. resistance, capacitance, etc.) that may be changed through the application of energy such as, for example, heat, light, voltage potential, or electrical current. Examples of a phase change material include a chalcogenide material.

Memory 100 includes column lines 141-143 and row lines 151-153 to select a particular memory cell of the array during a write or read operation. Column lines 141-143 and row lines 151-153 may also be referred to as word lines or address lines since these lines are used to address memory cells 111-119 during programming or reading. Column lines 141-143 may also be referred to as bit lines.

Memory elements 130 are connected to row lines 151-153 and are coupled to column lines 141-143 via select devices 120, 125. While two devices 120, 125 are depicted, more select devices may also be used. Therefore, when a particular memory cell (e.g., memory cell 115) is selected, voltage potentials are applied to the column line (e.g., 142) and row line (e.g., 152) associated with this memory cell to apply a voltage potential across the memory cell.

Series connected select devices 120 and 125 are used to access memory element 130 during programming or reading of memory element 130. A select device is an ovonic threshold switch that is made of a chalcogenide alloy that does not exhibit an amorphous to crystalline phase change and which undergoes rapid, electric field initiated change in electrical conductivity that persists only so long as a holding voltage is present. Select devices 120, 125 operate as a switch that is either "off" or "on" depending on the amount of voltage potential applied across the memory cell, and more particularly whether the current through the select device exceeds its threshold current or voltage, which then triggers the device into the on state. The off state is a substantially electrically nonconductive state and the on state is a substantially conductive state, with less resistance than the off state. In the on state, the voltage across the select device is equal to its holding voltage V_{H} plus IxRon, where Ron is the dynamic resistance from V_{H}. For example, select devices 120, 125 have threshold voltages and, if a voltage potential less than the threshold voltage of a select device 120, 125 is applied across select devices 120, 125, then at least one select device 120 or 125 remains "off" or in a relatively high resistive state so that little or no electrical current passes through the memory cell and most of the voltage drop from selected row to selected column is across the select device. Alternatively, if a voltage potential greater than the threshold voltages of select devices 120, 125 is applied across select devices 120, 125, then both select devices 120, 125 "turn on," i.e., operate in a relatively low resistive state so that electrical current passes through the memory cell. In other words, select devices 120, 125 are in a substantially electrically nonconductive state if less than a predetermined voltage potential, e.g., the threshold voltage, is applied across select devices 120, 125. Select devices 120, 125 are in a substantially conductive state if greater than the predetermined voltage potential is applied across select devices 120, 125. Select devices 120, 125 may also be referred to as an access device, an isolation device, or a switch.

Each select device 120, 125 comprises a switching material such as, for example, a chalcogenide alloy, and may be referred to as an ovonic threshold switch, or simply an ovonic switch. The switching material of select devices 120, 125 is a material in a substantially amorphous state positioned between two electrodes that is repeatedly and reversibly switched between a higher resistance "off" state (e.g., greater than about ten MOhms) and a relatively lower resistance "on" state (e.g., about one thousand Ohms in series with V_{H}) by application of a predetermined electrical current or voltage potential.

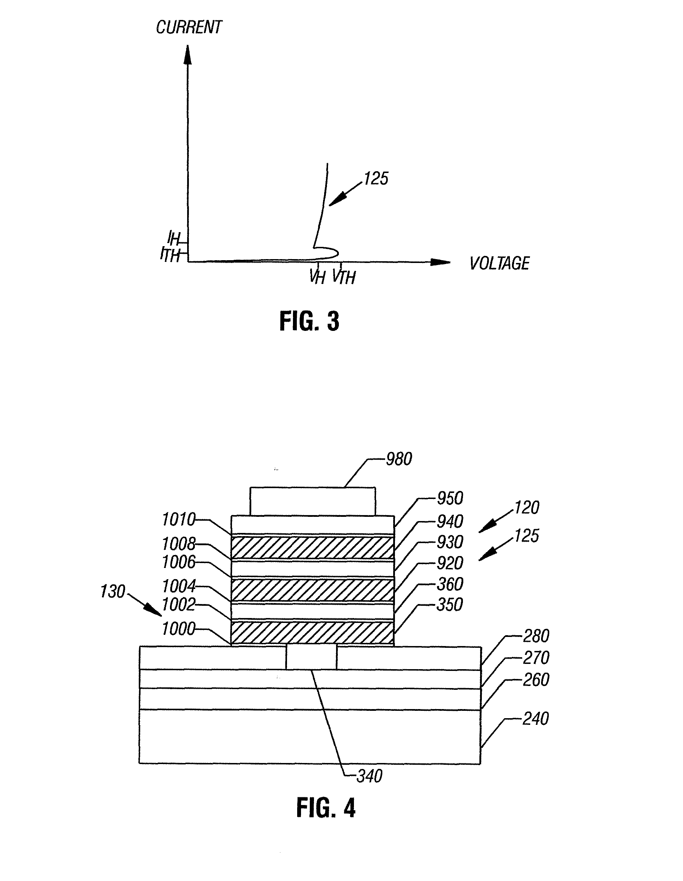

In this embodiment, each select device 120, 125 is a two terminal device that has a current-voltage (I-V) characteristic similar to a phase change memory element that is in the amorphous state. However, unlike a phase change memory element, the switching material of select devices 120, 125 does not change phase. That is, generally, the switching material of select devices 120, 125 is not a programmable material, and, as a result, select devices 120, 125 are not a memory device capable of storing information. For example, the switching material of select devices 120, 125 remains permanently amorphous and the I-V characteristic remains the same throughout the operating life. A representative example of I-V characteristics of select devices 120, 125 is shown in Figs. 2 and 3.

According to Fig. 2, in the low voltage or low electric field mode, i.e., where the voltage applied across select device 120 is less than a threshold voltage (labeled V_{TH}), select device 120 is "off" or nonconducting, and exhibits a relatively high resistance, e.g., greater than about 10 MOhms. Select device 120 remains in the off state until a sufficient voltage, e.g., V_{TH}, is applied, or a sufficient current is applied, e.g., I_{TH}, that switches select device 120 to a conductive, relatively low resistance on state. After a voltage potential greater than about V_{TH} is applied across select device 120, the voltage potential across select device 120 drops ("snapbacks") to a holding voltage potential, labeled V_{H}. Snapback refers to the voltage difference between V_{TH} and V_{H} of a select device.

In the on state, the voltage potential across select device 120 remains close to the holding voltage of V_{H} as current passing through select device 120 is increased. Select device 120 remains on until the current through select device 120 drops below a holding current, labeled I_{H}. Below this value, select device 120 turns off and returns to a relatively high resistance, nonconductive off state until the V_{TH} and I_{TH} are exceeded again.

In one embodiment, the first select device 120 (Fig. 2) has a higher resistance and a higher threshold voltage (V_{TH}) than the second select device 125 (Fig. 3). The first select device 120 may also have a higher activation energy. The threshold and holding voltages of the second select device 125 may be substantially equal and, in one embodiment, the snapback voltage is less than 0.25 V. The second select device 125 has higher leakage than the first select device 120 and a V_{TH} substantially equal to or less than its V_{H}. If the V_{TH} is less than V_{H}, snapback voltage is minimized. Preferably, V_{H} of second select device 125 is greater than snapback voltage of first select device 120. When both devices 120 and 125 are switched on, the V_{H} of the two devices in series is equal to the sum of the hold voltage across each device when both devices are on. The combined devices 120, 125 have a V_{H} comparable to the snapback of the first select device 120. Then, by adjusting the threshold current of device 120 to be considerably less than the threshold current of second select device 125, the voltage across second select device 125 is minimized at the time that first select device 120 triggers, which will minimize snapback voltage. If V_{H} of the second select device 125 is greater than the snapback voltage of the first select device 120 and about equal to threshold voltage of select device 125, then the devices 120 and 125 will operate together with little snapback voltage when the combination is switched from off to on upon application of current greater than the higher threshold current of the pair, which may be the threshold current of the second select device 125. In one embodiment, the resistance of first select device 120 may be ten times that of select device 125 at the time that the first select device 120 switches on, so most of the voltage drop is across first select device 120.

Turning to Fig. 4, an embodiment of a memory cell (e.g., 115) of memory 100 is arranged in a vertical stack. However, other configurations may also be used including configurations in which the order of the devices is changed, and including configurations with two or three discrete stacks wired in series. Memory cell 115 comprises a substrate 240, an insulating material layer 260 overlying substrate 240, and a conductive material layer 270 overlying insulating material layer 260. Conductive material layer 270 may be an address line (e.g., row line 152). Above conductive material layer 270, an electrode 340 is formed between portions of insulating material layer 280.

Over electrode 340, sequential layers of a memory material 350, electrode material 360, a switching material 920, such as a non-programmable chalcogenide with a lower threshold current and higher threshold voltage relative to its V_{H}, an electrode material 930, a switching material 940, such as a non-programmable chalcogenide with a higher threshold current and lower threshold voltage about equal to V_{H}, an electrode material 950, and a conductive material 980 are deposited to form a vertical memory cell structure. Conductive material 980 may be an address line (e.g., column line 142).

The substrate 240 is, for example, a semiconductor substrate (e.g., a silicon substrate). Other suitable substrates may be, but are not limited to, substrates that contain ceramic material, organic material, or a glass material.

An insulating material layer 260 is formed over and contacting substrate 240. Insulating material layer 260 may be a dielectric material that is thermally and/or electrically insulating such as, for example, silicon dioxide. Insulating material layer 260 has a thickness ranging from about 30 nm to about 1000 nm. Insulating material layer 260 is planarized using a chemical or chemical-mechanical polish (CMP) technique.

Conductive material layer 270 is thin film formed overlying insulating material layer 260 using, for example, a physical vapor deposition (PVD) process. Conductive material layer 270 is patterned using photolithographic and etch techniques to have a small width in the y-direction (orthogonal to the view shown in Fig. 4). The film thickness of conductive material layer 270 may range from about 2 nm to about 200 nm. In one embodiment, the thickness of conductive material layer 270 ranges from about 20 nm to about 100 nm. In another embodiment, the thickness of conductive material layer 270 is about 50 nm.

Conductive material layer 270 may be an address line of memory 100 (e.g., row line 151, 152, or 153). Conductive material layer 270 may be, for example, a tungsten (W) film, a doped polycrystalline silicon film, a Ti film, a TiN film, a TiW film, an aluminum (Al) film, a copper (Cu) film, or some combination of these films. In one embodiment, conductive material layer 270 is a polycrystalline silicon film with a resistance lowering strap of a refractory silicide on its top surface.

An insulating dielectric material layer 280 is formed overlying conductive material layer 270 using, for example, a PECVD (Plasma Enhanced Chemical Vapor Deposition) process, HDP (High Density Plasma) process, or spin-on and bake sol gel process. Insulating material layer 280 is a dielectric material with thermal and/or electrical insulating properties such as, for example, silicon dioxide. Insulating material layer 280 has a thickness ranging from about 10 nm to about 400 nm. In one embodiment, the thickness of insulating material layer 280 ranges from about 50 nm to about 250 nm. In another embodiment, the thickness of insulating material layer 280 is about 120 nm.

Insulating material layer 280 is preferably planarized using a chemical or CMP technique. The resulting thickness of insulating material layer 280 ranges from about 2 nm to about 400 nm. In one embodiment, after planarizing insulating material layer 280, the thickness of insulating material layer 280 ranges from about 20 nm to about 200 nm. In another embodiment, the thickness of insulating material layer 280 is about 90 nm.

The electrode 340 forms a heater for the switching of memory material 350, in a known way.

Memory material 350 is a phase change, programmable material capable of being programmed into one of at least two memory states by applying a current to memory material 350 to alter its phase between a substantially crystalline state and a substantially amorphous state, wherein the resistance of memory material 350 in the substantially amorphous state is greater than the resistance of memory material 350 in the substantially crystalline state.

Programming of memory material 350 to alter the state or phase of the material may be accomplished by applying voltage potentials to conductive materials 340 and 980, thereby generating a voltage potential across select devices 120, 125 and memory element 130. When the voltage potential is greater than the threshold voltages of select devices 120, 125 and memory element 130, then an electrical current flows through memory material 350 in response to the applied voltage potentials, and results in heating of memory material 350.

This heating may alter the memory state or phase of memory material 350. Altering the phase or state of memory material 350 alters the electrical characteristic of memory material 350, e.g., the resistance of the material is altered by altering the phase of the memory material 350. Memory material 350 may also be referred to as a programmable resistive material.

In the "reset" state, memory material 350 is in an amorphous or semi-amorphous state and in the "set" state, memory material 350 is in an a crystalline or semi-crystalline state. The resistance of memory material 350 in the amorphous or semi-amorphous state is greater than the resistance of memory material 350 in the crystalline or semi-crystalline state. It is to be appreciated that the association of reset and set with amorphous and crystalline states, respectively, is a convention and that at least an opposite convention may be adopted.

Using electrical current, memory material 350 is heated to a relatively higher temperature to amorphosize memory material 350 and "reset" memory material 350 (e.g., program memory material 350 to a logic "0" value). Heating the volume of memory material 350 to a relatively lower crystallization temperature crystallizes memory material 350 and "sets" memory material 350 (e.g., program memory material 350 to a logic "1" value). Various resistances of memory material 350 may be achieved to store information by varying the amount of current flow and duration through the volume of memory material 350.

Glue layers 1000 and 1002 are formed on opposite sides of the material 350. Glue layers 1000 and 1002 may have a thickness of less than 50 nm and are intended to improve the adherence of memory material 350 to over- and underlying layers. The glue layers 1000 and 1002 are an alloy of the form TiₐXN_{b} where X may, for example, be silicon, aluminum, carbon, or boron, as a few examples. The nitrogen, which may be in the form of nitride, may be anywhere from 0 to about 50 atomic percent. In one advantageous embodiment, the nitrogen content may be about 30 atomic percent. The glue layers 1000 and 1002 may be applied by reactive sputtering with controlled N₂ flow.

According to another embodiment, the glue layers 1000 and 1002 are formed of TiSi_{X} where x is from 1 to 2, including TiSi and TiSi₂. In this case, the Si material may reduce titanium diffusion.

Because of the strong bond between titanium in the glue layers 1000, 1002 and tellurium in the material 350, good adhesion may be achieved. The titanium atoms are chemically bonded and immobilized through alloying or partial nitridation to reduce titanium diffusion. The ratio of titanium to nitride may be adjusted to balance adhesion and titanium diffusion reduction.

Glue layers 1004, 1006, 1008, and 1010 may be used in some embodiments as well. They are designed in the same way as the glue layers 1000, 1002 described above.

Second select device 125 includes a bottom electrode 360 and a switching material 920 overlying bottom electrode 360. In other words, switching material 920 is formed over and contacting bottom electrode 360. In addition, second select device 125 includes a top electrode 930 overlying switching material 920.

Bottom electrode 360 is a thin film material having e.g. a film thickness ranging from about 2 nm to about 200 nm. In one embodiment, the thickness of electrode 360 ranges from about 10 nm to about 100 nm. In another embodiment, the thickness of electrode 360 is about 30 nm. Suitable materials for bottom electrode 360 include titanium (Ti), titanium nitride (TiN), titanium tungsten (TiW), carbon (C), silicon carbide (SiC), titanium aluminum nitride (TiAlN), titanium silicon nitride (TiSiN), polycrystalline silicon, tantalum nitride (TaN), some combination of these films, or other suitable conductors or resistive conductors compatible with switching material 940.

Switching material 920 is a thin film material having a thickness ranging from about 2 nm to about 200 nm. In one embodiment, the thickness of switching material 920 ranges from about 20 nm to about 100 nm. In another embodiment, the thickness of switching material 920 is about 50 nm.

Switching material 920 is formed overlying bottom electrode 360 using a thin film deposition technique such as, for example, a chemical vapor deposition (CVD) process or a physical vapor deposition (PVD). Switching material 920 is a thin film of a chalcogenide material or an ovonic material in a substantially amorphous state that may be repeatedly and reversibly switched between a higher resistance "off" state and a relatively lower resistance "on" state by application of a predetermined electrical current or voltage potential. Switching material 920 is a nonprogrammable material.

In one example, the composition of switching material 920 comprises a Si concentration of about 14%, a Te concentration of about 39%, an As concentration of about 37%, a Ge concentration of about 9%, and an In concentration of about 1%. In another example, the composition of switching material 940 comprises a Si concentration of about 14%, a Te concentration of about 39%, an As concentration of about 37%, a Ge concentration of about 9%, and a P concentration of about 1%. In these examples, the percentages are atomic percentages which total 100% of the atoms of the constituent elements.

In another embodiment, switching material 920 includes an alloy of arsenic (As), tellurium (Te), sulfur (S), germanium (Ge), selenium (Se), and antimony (Sb) with respective atomic percentages of 10%, 21%, 2%, 15%, 50%, and 2%.

In other embodiments, switching material 920 includes Si, Te, As, Ge, sulfur (S), and selenium (Se). As an example, switching material 940 comprises a Si concentration of about 5%, a Te concentration of about 34%, an As concentration of about 28%, a Ge concentration of about 11%, a S concentration of about 21%, and a Se concentration of about 1%.

Top electrode 930 is a thin film material having a thickness ranging from about 2 nm to about 200 nm. In one embodiment, the thickness of electrode 930 ranges from about 10 nm to about 100 nm. In another embodiment, the thickness of electrode 930 is about 30 nm. Suitable materials for top electrode 230 include a thin film of titanium (Ti), titanium nitride (TiN), titanium tungsten (TiW), carbon (C), silicon carbide (SiC), titanium aluminum nitride (TiAlN), titanium silicon nitride (TiSiN), polycrystalline silicon, tantalum nitride (TaN), some combination of these films, or other suitable conductors or resistive conductors compatible with switching material 920.

In one embodiment, top electrode and bottom electrode comprise carbon and have a thickness of about 50 nm. Top electrode 930 may also be referred to as an upper electrode and bottom electrode 360 may also be referred to as a lower electrode. In this embodiment, first select device 125 may be referred to as a vertical structure since electrical current flows vertically through switching material 920 between top electrode 930 and bottom electrode 360. Second select device 125 may be referred to as a thin film select device if thin films are used for switching material 920 and electrodes 930 and 360.

The threshold current (I_{TH}) of select device 125 is less than the threshold current for an ovonic memory device set in a high resistance, amorphous state. Preferably, the resistance of the select devices 120, 125 at the time that the select devices switch on is much greater, such as ten times greater, than the resistance of the memory element 130, so that when a select device 120 or 125 is switched on, most of the voltage is across the select device to minimize variation in the voltage at which the select device switches.

The threshold voltage (V_{TH}) of second select device 125 may be altered by changing process variables such as, for example, the thickness or alloy composition of switching material 920 and the active area of the contacting electrode. For example, increasing the thickness of switching material 920 increases the threshold voltage of second select device 125, with the result that the snapback voltage is increased if V_{H} of the device remains the same. The holding voltage (V_{H}) of second select device 125 is altered or set by the type of contact to switching device 125, e.g., the composition of electrodes 360 and 930 determines the holding voltage of select device 125.

Switching material 940 and electrodes 930 and 950 form the first select device 120. Switching material 940 is formed using similar but different materials and similar but different manufacturing techniques used to form switching material 920 described herein. Switching materials 920 and 940 may be composed of different materials. For example, in one embodiment, switching material 920 is composed of a chalcogenide material and switching material 940 is composed of a different chalcogenide material.

The threshold voltage of a select device 120 or 125 is determined by the thickness or alloy composition of the switching material of the ovonic switch and the holding voltage of an ovonic switch is determined by the composition of the electrodes contacting the switching material of the ovonic switch. Accordingly, in one embodiment, the snapback voltage of the device 125 is reduced by reducing the thickness of the switching material and using a particular type of electrode.

In one embodiment, the switching material 920 is thinner than the thickness of switching material 940 to reduce leakage. Alternatively, the material 920 may be made of a lower leakage alloy such as an allow with a higher semiconductor bandgap in the range of 0.8eV to 1.0eV, such as an As, Se, Ge alloy with 20% to 40% Ge. One suitable alloy includes (in atomic percentages) 10% As, 21% Te, 2% S, 15% Ge, 50% Se and 2% Sb, with a bandgap of about 0.85eV. As another example, the switching element 920 may have a smaller area measured in the horizontal direction to reduce leakage.

The second select device 125 may be made using a different alloy as the switching material 940 (e.g., Te 39%, As 37%, Si 17%, Ge 7%), with 10 to 20% added silicon. The alloy for the material 940 may be a higher leakage alloy.

In this embodiment, the threshold voltage of first select device 120 is about 3 V and the holding voltage of first select device 120 is about 1 V. The threshold voltage of second select device 125 is about 1.1 V or less and the holding voltage of select device 125 is about 1 V. The threshold voltage of the device 130 is less than the snapback voltage of the series combination of devices 120 and 125, so that V_{TH} of the memory device 130 is not exceeded when the select device snaps back. To further reduce the snapback voltage, more than one device like the second select device 125 may be placed in series with the first select device 120. As still another option, the first select device 120 may be made of a material with a higher activation energy. In some embodiments, the device 120 may be formed of a chalcogenide having a higher glass transition temperature.

Further, the leakage and the threshold current of the first select device 120 may be less than the leakage of the second select device 125 and the memory element 130 so that, until the first select device 120 triggers (as its voltage exceeds its threshold voltage), the voltage across the second select device 125 and the memory element 130 may be minimized to a relatively insignificant voltage, and the leakage into the series combination minimized when deselected. In one embodiment, that voltage across memory element 130 is less than 10% of the voltage across the first select device 120 until it is triggered. For example, the resistance across the second select device 125 and the memory element 130 can be ten times less than the resistance across the first select device 120 until the first select device 120 triggers by exceeding its threshold voltage. The increase in threshold voltage for the combined series set of the devices is a resistor divider across the first select device 120. That is, the increase, relative to the total voltage across selected row and column voltage, that is across first select device 120, is proportionate to the voltage drop across the second select device 125 and the memory element 130, which can be reduced by increasing the leakage and decreasing the resistance of the second select device 125 relative to first select device 120 at the time first select device 120 switches on. Maintaining the select devices 120 and 125 in the V_{H} on state is assured by maintaining the current greater than I_{H} of both after they switch on, and the holding current and threshold currents (I_{TH}) of the select device 120 or 125 (I_{TH}) may be adjusted to be less than the I_{TH} current of memory element 130.

For example, if the first select device 120 triggers at 3.3 V across the select devices 120 and 125, and memory element 130 to a holding voltage of 1 V, this leaves 2.3 V across the remaining second select device 125 and memory element 130. The 2.3 V is adequate to trigger second select device 125, and the relative resistances of second select device 125 and memory element 130 may be such that most of the voltage is across the second select device 125. In this situation, only second select device 125 switches, leaving the memory element 130 unswitched with the balance of the voltage across it (above voltage device 120 + V_{H} device 125). Thereby the holding voltage of the second select device 125 is added to the holding voltage of the first select device 120, with the balance of the voltage across the memory element 130. The resulting snapback voltage of the combination of devices 120 and 130 is 3.3 V minus V_{H} of device 120 minus V_{H} of second select device 125 minus the voltage across memory element 130, say 1.3V. This voltage can be further reduced by increasing the holding voltage of any of the devices or by reducing the threshold voltage of any of the devices 120 or 125 or by adding additional devices such as second select device 125 to the series combination.

After the devices 120 and 125 trigger, the balance of the voltage developed on the bitline, above the row line, is then across the memory element 130. As the voltage increases when the column line is driven by a current source, the voltage can be read as a one when memory element 130 is reset because the column line voltage keeps increasing and exceeds the sensor or reference voltage. If, after a reasonable period of time, the column line does not exceed the reference voltage, then the bit is set and in the lower resistance state.

For a combined select device and memory element that has no snapback, the total voltage across the combined devices 120 and 125 increases as the increasing current is forced into the pair. If the threshold voltage of the first select device 120 is equal to the holding voltage thereof plus the holding voltage of the second select device 125, and the threshold voltage of the second select device 125 equals the holding voltage thereof, then the snapback voltage of the device 120 is absorbed in the increase of voltage across the second select device 125 without the memory device 130 thresholding, then the selection devices in series appear to have no snapback voltage in combination. To absorb the snapback voltage of the first select device 125, the threshold voltage of the first select device 120, minus the holding voltage thereof, must be less than the threshold voltage of second select device 125, which is preferably less than holding voltage thereof.

As an example, if the threshold voltage of the second select device 125 equals the holding voltage thereof, which in this example is 1.5 V, and the threshold voltage of the first select device 120 is 2.6 V with a holding voltage of 1.5 volts, then the voltage across the second select device 125 at the threshold of the first select device 120 is equal to 0.4 V. The resistance of the second select device 125 at a threshold current of the first select device 120 flowing through it may be about 10% of the resistance of the first select device 120 at its threshold voltage. So immediately prior to the first select device 120 thresholding, the voltage across the first select device 120 is 2.6 V, the voltage across the second select device 125 is 0.3 V and the total voltage is 2.9 V.

After the first select device 120 thresholds, the voltage across it is equal to its holding voltage or 1.5 V, while the voltage across the second select device 125 is 1.4 V, which is still below both the threshold voltage and the holding voltage of the memory element 130. The total voltage then is 2.9 V without snapbacks since an additional 0.1 V needs to be applied across the second select device 125 before it snaps back.

As still another example, the second select device 125 may have a threshold voltage equal to its holding voltage which is 1.5 V and the threshold voltage of the first select device 120 can be 2.6 V with a holding voltage of 1.5 V. Then, immediately prior to the device 120 thresholding, the first select device 120 has 2.6 V across it, the second select device 125 has 0.7 V across it, for a total of 3.3 V, and memory element 130 has 0.2 V, for a total of 3.5 V between row and column lines. After thresholding of the first select device 120, the first select device 120 has a V_{H} of 1.5 V, second select device 125 has a V_{H} of 1.5 V, and the memory element 130 has increased to 0.5 V, so there a 0.2 V snapback since the memory element 130 now sees this increase in voltage across it without an increase from row to column voltage.

Thus, the voltage across the memory element 130 to switch also determines the amount of snapback and this is determined by the relative resistances when the first select device 120 switches. However, even though the thicker first select device 120 can be viewed as having a higher resistance and, hence, the most voltage drop, at the time immediately prior to its thresholding, it has a full threshold voltage across it, whereas the second select device 125 only has a fraction of its threshold voltage across it. The amount of snapback voltage for the combined devices 120 and 125 is then developed across the memory element 130 and results in current flow that may exceed the holding current of the devices 120 and 125 so that stable voltages are established and maintained as the current increases in memory element 130.

Thus, in some embodiments, lower leakage is preferred in first select device 120. The increased snapback contributed by first select device 120 is counteracted by the second select device 125. In some embodiments, the combination of devices 120 and 125 result in lower leakage and less snapback when the series combination is used as the select device for memory element 130.

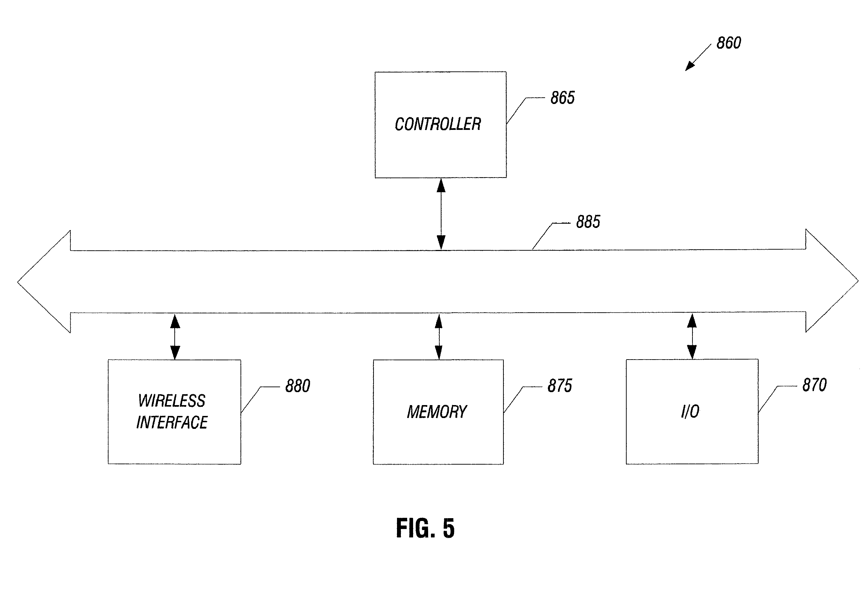

Turning to Fig. 5, a portion of a system 860 in accordance with an embodiment of the present invention is described. System 860 may be used in wireless devices such as, for example, a personal digital assistant (PDA), a laptop or portable computer with wireless capability, a web tablet, a wireless telephone, a pager, an instant messaging device, a digital music player, a digital camera, or other devices that are adapted to transmit and/or receive information wirelessly. System 860 may be used in any of the following systems: a wireless local area network (WLAN) system, a wireless personal area network (WPAN) system, a cellular network, although the scope of the present invention is not limited in this respect.

System 860 includes a controller 865, an input/output (I/O) device 870 (e.g. a keypad, display), a memory 875, and a wireless interface 880 coupled to each other via a bus 885.

Controller 865 may comprise, for example, one or more microprocessors, digital signal processors, microcontrollers, or the like. Memory 875 may be used to store messages transmitted to or by system 860. Memory 875 may also optionally be used to store instructions that are executed by controller 865 during the operation of system 860, and may be used to store user data. Memory 875 may be provided by one or more different types of memory. For example, memory 875 may comprise any type of random access memory, a volatile memory, a non-volatile memory such as a flash memory and/or a memory such as memory 100 discussed herein.

I/O device 870 may be used by a user to generate a message. System 860 uses wireless interface 880 to transmit and receive messages to and from a wireless communication network with a radio frequency (RF) signal. Examples of wireless interface 880 include an antenna or a wireless transceiver.

Finally, it is clear that numerous variations and modifications may be made to method and apparatus described and illustrated herein, all falling within the scope of the invention as defined in the attached claims.

## Claims

1. A phase change device (100), comprising:
a phase change memory material layer (350); and
an adhesion layer (1000, 1002, 1004, 1006, 1008, 1010) in contact with said phase change memory material layer, said adhesion layer including titanium and a component in a quantity sufficient to effectively reduce the diffusion of titanium without substantially affecting the adhesion properties of the adhesion layer.

2. The device of claim 1, wherein said adhesion layer (1000, 1002, 1004, 1006, 1008, 1010) is an alloy of the form TiₐX_{b}N_{c} where X is selected in the group comprising silicon, aluminum, carbon, or boron, and c may be 0.

3. The device of claim 2, wherein said adhesion layer (1000, 1002, 1004, 1006, 1008, 1010) includes less than 50 atomic percent nitrogen.

4. The device of claim 2 or 3, wherein said adhesion layer (1000, 1002, 1004, 1006, 1008, 1010) includes about 30 atomic percent nitrogen.

5. The device of any of claims 2-4, wherein N is in the form of nitride.

6. The device of claim 2, wherein said adhesion layer (1000, 1002, 1004, 1006, 1008, 1010) is TiSi_{X} and x is from 1 to 2.

7. The device of any of claims 1-6, wherein said adhesion layer (1000, 1002, 1004, 1006, 1008, 1010) is less than 50 nm thick.

8. The device of any of claims 1-7, wherein said phase change memory material layer (350) includes a chalcogenide.

9. The device of claim 8, wherein said chalcogenide includes tellurium.

10. The device of any of claims 1-9, comprising a resistive heater (340) formed in an insulating layer (280), said adhesion layer (1000) overlying said insulating layer (280) and said phase change memory material layer (350) overlying said adhesion layer (1000) and said resistive heater (340); the device further comprising a stack overlying said phase change memory material layer (350) and including a first adhesion layer (1002), a bottom electrode (360), a second adhesion layer (1004), a first switching material (920), a third adhesion layer (1006) and an upper electrode (930), said first, second and third adhesion layer (1002, 1004, 1006) being an alloy of the form TiₐX_{b}N_{c} where X is selected in the group comprising silicon, aluminum, carbon, or boron, and c may be 0.

11. The device of claim 10, wherein said stack further comprises a fourth adhesion layer (1008), a second switching material (940) and a fifth adhesion layer (1010) overlying said upper electrode (930), said fourth and fifth adhesion layers (1008, 1010) being an alloy of the form TiₐX_{b}N_{c} where X is selected in the group comprising silicon, aluminum, carbon, or boron, and c may be 0.

12. A method for manufacturing a phase change device comprising:
forming an adhesion layer (1000, 1002, 1004, 1006, 1008, 1010) on a phase change material layer (350), said adhesion layer including a component in a quantity sufficient to effectively reduce the diffusion of titanium without substantially affecting the adhesion properties of the adhesion layer.

13. The method of claim 12, wherein said adhesion layer (1000, 1002, 1004, 1006, 1008, 1010) is an alloy of the form TiₐX_{b}N_{c} where X is selected in the group comprising silicon, aluminum, carbon, or boron, and c may be 0.

14. The method of claim 13, including forming said adhesion layer (1000, 1002, 1004, 1006, 1008, 1010) with less than 50 atomic percent nitrogen.

15. The method of claim 13 or 14, including forming said adhesion layer (1000, 1002, 1004, 1006, 1008, 1010) with about 30 atomic percent nitrogen.

16. The method of any of claims 12-15, including forming said phase change material (350) of chalcogenide.

17. The method of claim 16, wherein said chalcogenide (350) includes tellurium.

18. The method of any of claims 12-17, wherein said adhesion layer (1000, 1002, 1004, 1006, 1008, 1010) has a thickness of less than 50 nm.

19. The method of any of claims 12-18, wherein N is in the form of nitride.

20. The method of claims 12-19, wherein said adhesion layer is formed by reactive sputtering.

21. The method of claim 20, including providing a flow of nitrogen gas while sputtering.

22. The method of any of claims 12, 13 and 16-21 when depending upon claims 12, 13, including forming said adhesion layer (1000, 1002, 1004, 1006, 1008, 1010) with TiSiₓ where x is from 1 to 2 and said component is silicon.

23. A system (860), comprising:
a processor (865);
an interface (870) coupled to the processor; and
a memory (875) coupled to the processor, the memory including a phase change device (100) according to any of claims 1-11.

24. The system of claim 23, wherein said interface (870) is a wireless interface.

25. The system of claim 22 or 23, wherein said interface (870) includes a dipole antenna.
